# EUROPÄISCHE PATENTSCHRIFT

(11) **EP 1 270 504 B1**
(45) Veröffentlichungstag und Bekanntmachung des Hinweises auf die Patenterteilung: **26.05.2004**
(21) Anmeldenummer: 01115136.2
(22) Anmeldetag: 22.06.2001
(51) Int. Cl.: B81B 3/00, B81C 1/00

(54) **Halbleiterbauelemente in einem Waferverbund**
Semiconductor device joint to a wafer
Dispositif à semiconducteur attaché à un wafer

(43) Veröffentlichungstag der Anmeldung: 02.01.2003
(73) Patentinhaber: Nanoworld AG, 2007 Neuchâtel (CH)
(72) Erfinder: Lutter, Stefan, 92358 Seubersdorf i.d. Opf. (DE)
(74) Vertreter: Klocke, Peter, Dipl.-Ing.

(56) Entgegenhaltungen:
- DE-A- 19 734 530
- US-A- 4 670 092
- PATENT ABSTRACTS OF JAPAN vol. 016, no. 337 (P-1390), 22. Juli 1992 (1992-07-22) -& JP 04 102066 A (MITSUBISHI ELECTRIC CORP), 3. April 1992 (1992-04-03)
- PATENT ABSTRACTS OF JAPAN vol. 1999, no. 12, 29. Oktober 1999 (1999-10-29) -& JP 11 186565 A (JAPAN AVIATION ELECTRON IND LTD), 9. Juli 1999 (1999-07-09)
- PETERSEN K E: "SILICON AS A MECHANICAL MATERIAL" PROCEEDINGS OF THE IEEE, IEEE. NEW YORK, US, Bd. 70, Nr. 5, 1. Mai 1982 (1982-05-01), Seiten 420-457, XP000565139 ISSN: 0018-9219

## Beschreibung

Halbleiterbauelemente in einem Waferverbund, bei dem die Bauelemente mit einem Rahmen über jeweils einer Halterung verbunden und aus demselben Siliziumwafer herausgearbeitet sind. Die Erfindung betrifft außerdem ein Verfahren zur Herstellung von Halbleiterbauelementen in einem derartigen Waferverbund.

Bei der Herstellung von Halbleiterbauelementen aus einem Siliziumwafer ((100)-Siliziumwafer) werden die einzelnen Bauelemente zusammen mit einem Rahmen und einer Halterung, die das Bauelement mit dem Rahmen verbindet, aus ein und demselben Siliziumwafer herausgearbeitet. Die Halterung besteht dabei aus einem Balken, der sich quer über das Bauelement erstreckt und beidseitig an dem Rahmen fixiert ist. Die Herstellung dieser Balken, die einzig und allein der Fixierung der Bauelemente an dem Rahmen dienen, erfolgt durch photolithographische Strukturierung der Wafervorderseite mit anschließenden trocken- oder nasschemischen Ätzprozessen zur Formgebung. Das Freilegen der Bauelemente und des Rahmens, d.h. die Trennung der Bauelemente vom Rahmen, erfolgt durch photolithographische Strukturierung der Wafervorderseite und/oder der Waferrückseite mit anschließenden trocken- oder nasschemischen Ätzprozessen zur Formgebung. Das Bauelement selbst wird dann aus dem Rahmen durch Ausüben von Druck auf das Bauelement, bis es zum Durchbrechen des Balkens kommt, herausgebrochen. Alternativ kann der Balken auch durch Torsionsbelastung durchgebrochen werden, in dem das Bauelement aus der Waferebene herausgedreht wird.

Bei dieser Art der Herstellung der Halbleiterbauelemente erfolgt die Herstellung der Balken von der Wafervorderseite, so dass alle Herstellungs- und Bearbeitungsprozesse des Halbleiterbauelements auf den Herstellungsprozess für die Balken abgestimmt sein müssen. Dadurch besteht eine starke Abhängigkeit zwischen Herstellung der Balken und Prozessierung des Halbleiterbauelements. In der Regel gibt es keine kristallographisch bevorzugten Bruchkanten, da diese zusätzliche Prozessschritte erforderlich machen. Damit entstehen beim Herausbrechen nicht reproduzierbare Bruchkanten an den Balken oder die Balken splittern beim Herausbrechen des Halbleiterbauelements, wobei diese Splitter zur Beschädigung des Halbleiterbauelements führen können. Ein weiterer Nachteil ist darin zu sehen, dass die Dicke der Balken üblicherweise durch zeitkontrolliertes Ätzen beim Freilegen der Halbleiterbauelemente definiert werden muss.

Im nächsteliegenden Stand der Technik, Dokument US-A-4670092 von M. E. Motamedi, ist ein Verfahren offenbart, um ein Beschleungungssensor herzustellen, wo ein (100) Siliziumwafer von der Rückseite nasschemisch geätzt wird, um eine an einem Rahmen verbundene Masse zu schaffen.

Der vorliegenden Erfindung liegt daher die Aufgabe zu Grunde, eine Möglichkeit vorzuschlagen, mit der die vorstehend erwähnten Nachteile beseitigt werden.

Diese Aufgabe wird erfindungsgemäß durch die Halbleiterbauelemente in einem Waferverbund mit den Merkmalen des Anspruchs 1 sowie durch ein Verfahren zur Herstellung von Halbleiterbauelementen mit den Merkmalen des Anspruchs 5 gelöst. Weitere vorteilhafte Ausgestaltungen sind den jeweiligen rückbezogenen Unteransprüchen zu entnehmen.

Danach weisen die Halbleiterbauelemente in einem Waferverbund eine Halterung auf, die einseitig das jeweilige Bauelement mit dem Rahmen verbindet und eine Sollbruchstelle besitzt. Grundsätzlich kann diese Sollbruchstelle verschiedenartig in Form einer Materialverdünnung im Bereich der Halterung ausgebildet sein. Vorteilhafterweise wird die Sollbruchstelle durch eine Grube zwischen dem Rahmen und dem Bauelement gebildet, die vorzugsweise V-förmig ausgebildet ist. Gemäß einer bevorzugten Ausführungsform stellen die Fläche der V-Grube (111)-Kristallebenen dar. Gemäß dem Verfahren erfolgt die Herstellung einer einseitigen Halterung, die jeweils das Bauelement mit dem Rahmen verbindet durch photolithographische Strukturierung der Waferrückseite mit und anschließendem Ätzen einer Grube in einem Bereich, in dem der Rahmen eine Verdickung aufweist. Das Freilegen der Bauelemente und des Rahmens erfolgt durch photolithographische Strukturierung der Wafervorderseite und/oder -rückseite mit anschließenden trocken- oder nasschemischen Ätzprozessen zur Formgebung. Bei geschickter Wahl der Prozesssequenz kann das Freilegen zeitgleich mit der Herstellung der Halterung erfolgen.

Das Herstellen der Sollbruchstelle kann grundsätzlich durch einen bekannten Ätzvorgang hergestellt werden, wobei gemäß einer bevorzugten Ausbildung des Verfahrens die V-Grube durch nasschemisches anisotropes Ätzen hergestellt wird.

Der letzte der drei vorstehend erwähnten Verfahrensschritte betreffend das Freilegen entspricht den auch beim Stand der Technik angewendeten Maßnahmen und ist allgemein bekannt. Jedoch erfolgt die lithographische Strukturierung der einseitigen Halterung von der Waferrückseite. Damit ist die Herstellung der Halterung vollkommen unabhängig von der Prozessierung der Wafervorderseite. Durch die Schnittkante der zusammenlaufenden kristallographischen (111)-Ebenen der V-Grube gemäß einer bevorzugten Ausbildung wird eine Sollbruchkante definiert. Durch die Ausübung von Druck auf das Bauelement kommt es zu dessen Verkippung und damit zum Herausbrechen des Halbleiterbauelements aus dem Rahmen entlang der Sollbruchkante. Damit entsteht eine definierte Bruchkante. Ein Splittern des Siliziumkristalls wird deutlich reduziert, wenn nicht sogar vermieden. Die Gefahr der Schädigung des Bauelements beim Herausbrechen wird damit ebenfalls deutlich reduziert.

Beim Zusammentreffen der beiden Flächen der V-Grube stoppt die Tiefenätzung auf Grund der kristallographischen Eigenschaften des Siliziums. Dadurch ist bei der Herstellung eine sehr einfache und zeitunabhängige Kontrolle der Dicke der Sollbruchstelle zu realisieren.

Grundsätzlich ist es auch denkbar, die vorstehend beschriebene Halterung an mehreren Seiten, beispielsweise beidseitig des Halbleiterbauelements gemäß dem Stand der Technik vorzusehen, wobei dann jedoch die vorstehend beschriebenen Vorteile hinsichtlich des Herausbrechens des Halbleiterbauelements nicht mehr in der vorstehend beschriebenen Art und Weise zutreffen, so dass es dann auch wieder zu Schädigungen des Halbleiterbauelements kommen kann.

Mit dem Verfahren wird eine kostengünstige und mit geringerem Ausschuss einhergehende Möglichkeit zur Herstellung von Halbleiterbauelemente in einem Waferverbund angegeben.

Nachfolgend wird die Erfindung anhand eines Ausführungsbeispiels in Verbindung mit den begleitenden Zeichnungen näher erläutert. Es stellen dar:
- Figur 1: die Draufsicht auf ein Halbleiterbauelement im Waferverbund gemäß dem Stand der Technik;
- Figur 2: die Draufsicht auf ein Halbleiterbauelement im Waferverbund gemäß der Erfindung und
- Figur 3: ein Ausführungsbeispiel zur Herstellung der Halterung eines Halbleiterbauelements im Waferverbund gemäß der Erfindung mit den einzelnen dazu notwendigen Prozessschritten.

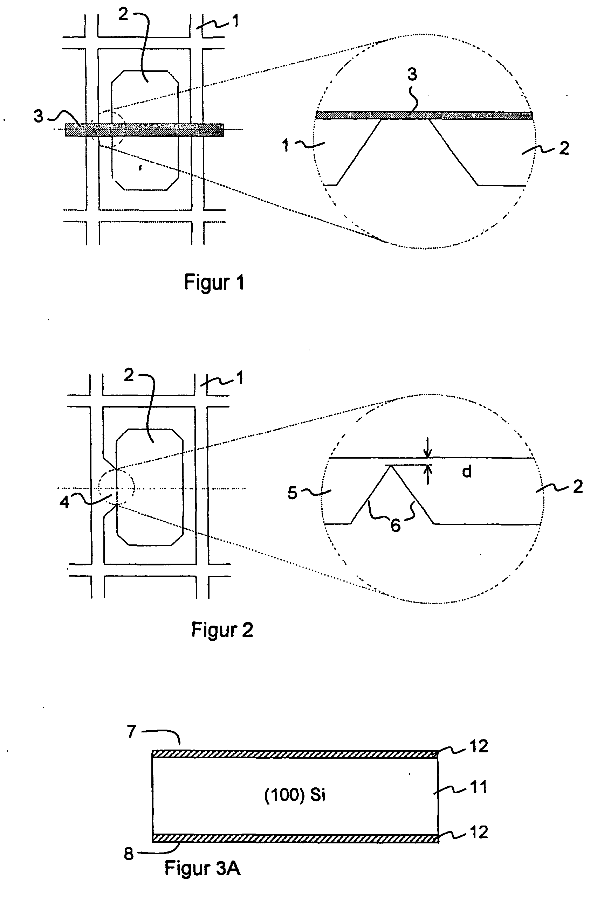

Figur 1 zeigt den Ausschnitt aus einem nicht dargestellten Siliziumwafer mit einem Rahmen 1, in dem das Halbleiterbauelement 2 befestigt ist. Das Halbleiterbauelement 2 wird über einen Balken 3 mit dem Rahmen verbunden. In der vergrößerten Ansicht ist erkennbar, dass der Balken 3 den Rahmen 1 und das Halbleiterbauelement 2 über eine gewisse Strecke verbindet, d.h. Halbleiterelement 2 und Rahmen 1 sind voneinander beabstandet.

Die Figur 2 zeigt eine Anordnung entsprechend der Figur 1, wobei die Herstellung des Halbleiterbauelements 2 in dem Rahmen 1 nach dem Verfahren gemäß der Erfindung erfolgt ist. Das Halbleiterbauelement 2 ist einseitig über eine Halterung 4 verbunden. Die Halterung 4 umfasst in diesem Bereich eine Verdickung 5 des Rahmens 1, so dass die Verdickung 5 direkt an das Halbleiterbauelement 2 angrenzt. Wie aus der vergrößerten Darstellung in der Figur 2 ersichtlich, ist zwischen der Verdickung 5 der Halterung 4 und dem Halbleiterbauelement 2 eine V-Grube 6 angeordnet, deren Flächen im Silizium so zusammentreffen, dass eine Restwandstärke mit der Dicke d übrig bleibt. Wie vorstehend bereits erwähnt, wird die Tiefenätzung auf Grund der kristallographischen Eigenschaften des Siliziums und der Tatsache, dass die Flächen (111)-Kristallebenen darstellen, gestoppt. Damit kann die Sollbruchstelle definiert hergestellt werden.

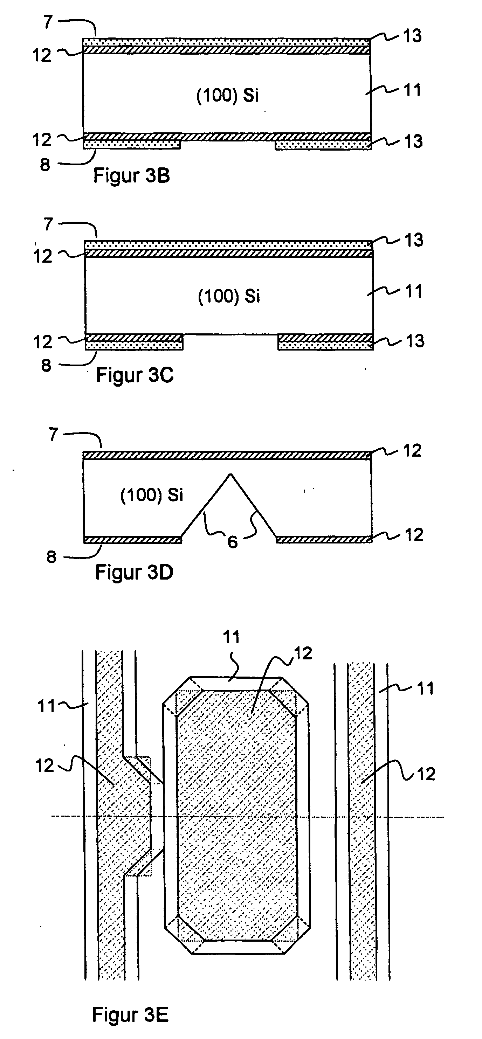

Die Figuren 3A bis 3E erläutern die einzelnen Prozessschritte zur Herstellung einer Halterung für Halbleiterbauelemente im Waferverbund gemäss der Erfindung. In diesem speziellen Ausführungsbeispiel wird davon ausgegangen, dass die Prozessierung des Bauelementes von der Vorderseite bereits abgeschlossen ist. In diesem Fall kann das Freilegen des Bauelementes zusammen mit der Herstellung der Haltevorrichtung erfolgen. Dies bedeutet, dass zusätzliche Prozessschritte zum Freilegen des Bauelementes entfallen.

Figur 3 A zeigt einen (100) Siliziumwafer 11 auf dessen Vorderseite (entspricht der Oberseite der Abbildung) sich die aktive Fläche des Bauelementes oder Sensors befinden soll. Dieser Siliziumwafer 11 wird von beiden Seiten mit einer Maskierschicht 12 bedeckt. Dies kann beispielsweise eine durch Oxidation erzeugte Siliziumoxidschicht, oder eine durch Abscheidung aus der Gasphase erzeugte Siliziumnitridschicht sein. Im Allgemeinen muss es sich um Schichten handeln, die als Ätzmaske für anisotropes Siliziumätzen geeignet sind.

Anschließend wird, wie in Figur 3B dargestellt, auf die Rückseite des Siliziumwafers 11 ein photosensitiver Lack 13 aufgebracht. In diesen Lack 13 wird durch photolithographische Strukturierung die Maske zur Herstellung der Halterung 4 übertragen. Anschließend wird auf die Wafervorderseite 7 zum Schutz derselben ebenfalls ein Lack 13 aufgebracht, der nicht strukturiert wird. Dabei kann auch ein anderer als der auf die Waferrückseite 8 aufgebrachte Lack verwendet werden.

Figur 3C zeigt den nächsten Schritt, in dem die in den Photolack 13 übertragene Maskenstruktur durch nass- oder trockenchemische Ätztechniken in die Maskierschicht 12 auf der Waferrückseite 8 übertragen wird. Besteht die Maskierschicht aus Siliziumoxid oder Siliziumnitrid kann dies durch Ätzen in verdünnter Flusssäure erfolgen.

Anschließend wird von beiden Seiten des Siliziumwafers 11 der Photolack 13 wieder entfernt. Dies kann beispielsweise in einem Lösungsmittel wie Aceton erfolgen. Um Lackreste vollständig zu entfernen kann nachfolgend eine Reinigung in einem erhitzten Gemisch aus Schwefelsäure und Wasserstoffperoxid erfolgen. Durch einen nachfolgenden anisotropen Siliziumätzschritt, der beispielsweise in verdünnter, erhitzter Kaliumhydroxidlösung stattfinden kann, wird eine V-Grube 6 in den Siliziumwafer 11 geätzt. Die Begrenzungsflächen dieser V-Grube 6 stellen dabei (111)-Kristallebenen des Siliziums dar. Die Tiefenätzung stoppt beim Zusammentreffen der beiden (111)-Kristallebenen automatisch. Dies ist in Figur 3D dargestellt.

Figur 3E zeigt eine Aufsicht auf die Rückseite des Siliziumwafers 11 nach Abschluss des anisotropen Siliziumätzens. Die zur Herstellung einer Halterung 4 gemäss der Erfindung notwendige Form der Ätzmaske 12 ist ebenfalls aus dieser Abbildung ersichtlich. Die auf der Wafervorderseite 7 befindliche Ätzmaskierung ist in dieser Figur nicht dargestellt.

Abschließend werden die Ätzmaskierungen 12 auf der Vorder- und Rückseite des Siliziumwafers 11 wieder entfernt. Bestehen diese Maskierschichten aus Siliziumoxid oder Siliziumnitrid kann dies erneut durch Ätzen in verdünnter Flusssäure erfolgen. Bei einem Siliziumätzschritt ausreichender Dauer besteht lediglich im Bereich der erzeugten Verdickung 5 des Rahmens 1 noch Kontakt zwischen Bauelement 2 und Rahmen 1. Ansonsten ist das Bauelement 2 vollständig vom Rahmen 1 getrennt (siehe Figur 2).

## Patentansprüche

1. Waferverbund mit Halbleiterbauelementen, bei dem die Bauelemente (2) mit einem Rahmen (1) über jeweils einer Halterung (4) verbunden sind und aus demselben Siliziumwafer (11) herausgearbeitet sind, wobei die Halterung (4) einseitig das jeweilige Bauelement (2) mit dem Rahmen (1) verbindet, **dadurch gekennzeichnet, dass** die Halterung (4) eine Sollbruchstelle (6) zum mechanischen Lösen des Bauelements (2) von dem Rahmen (1) aufweist.

2. Waferverbund nach Anspruch 1, **dadurch gekennzeichnet, dass** die Halterung (4) durch eine flächige Verdickung (5) des Rahmens und durch eine Grube (6) zwischen dem Rahmen (1) und dem Halbleiterbauelement (2) gebildet wird.

3. Waferverbund nach Anspruch 2, **dadurch gekennzeichnet, dass** die Grube (6) V-förmig ausgebildet ist.

4. Waferverbund nach Anspruch 3, **dadurch gekennzeichnet, dass** die Flächen (7) der V-Grube (111)-Kristallebenen darstellen.

5. Verfahren zur Herstellung von einem Waferverbund nach Anspruch 1, mit den folgenden Schritten:
photolithographische Strukturierung der Waferrückseite mit der einseitigen Halterung (4), die jeweils das Halbleiterbauelement (2) mit dem Rahmen (1) verbindet,
Herstellen der Sollbruchstelle (6) an der Halterung (4) mittels eines Ätzvorganges zwischen dem Rahmen (1) und dem Halbleiterbauelement (2), und
Freilegen der Bauelemente (2) und des Rahmens (1) durch photolithographische Strukturierung der Wafervorderseite und/oder -rückseite mit anschließenden trocken- oder nasschemischen Ätzprozessen zur Formgebung.

6. Verfahren nach Anspruch 5, **dadurch gekennzeichnet, dass** als Sollbruchstelle eine Grube (6) hergestellt wird.

7. Verfahren nach Anspruch 6, **dadurch gekennzeichnet, dass** die Grube (6) als V-Grube (6) ausgebildet wird.

8. Verfahren nach Anspruch 7, **dadurch gekennzeichnet, dass** die V-Grube (6) durch nasschemisches anisotropisches Ätzen hergestellt wird.

9. Verfahren nach Anspruch 8, **dadurch gekennzeichnet, dass** beim Ätzen eine V-Grube (6) hergestellt wird, deren Fläche (111)-Kristallebene darstellen.

## Claims

1. A wafer assembly with semiconductor components (2) in which the semiconductor components each are connected to a frame (1) by a holder (4) and are formed of the same silicon wafer (11), wherein the holder (4) connects at on side the respective semiconductor component (2) to the frame **characterised in that** the holder (4) comprises a desired breaking point (6) for mechanical release of the semiconductor component (2) from the frame (1).

2. The wafer assembly as claimed in claim 1, wherein the holder (4) is formed by a large-area thickened portion (5) of the frame (1) and a groove (6) between the frame (1) and the semiconductor component (2) .

3. The wafer assembly as claimed in claim 2, wherein the groove (6) is of V-shaped design.

4. The wafer assembly as claimed in claim 3, wherein the V-groove (6) has surfaces (7) which form (111)-crystal planes.

5. A method for fabricating a wafer assembly, according to claim 1 comprising the following steps:
photolithographic patterning of the wafer back surface with the holder (4) on one side, wherein the holder (4) connects the semiconductor component (2) to the frame (1),
producing a desired breaking point (6) on the holder (4) by means of an etching operation between the frame (1) and the semiconductor component(2); and
opening up the semiconductor components (2) and the frame (1) by photolithographic patterning of the wafer front surface and or back surface an with subsequent chemical etching for shaping.

6. The method as claimed in claim 5, including producing a groove (6) as the desired breaking point.

7. The method as claimed in claim 6, including producing a V-shaped groove (6).

8. The method as claimed in claim 7, wherein the V-shaped groove (6) is produced by wet-chemical anisotropic etching.

9. The method as claimed in claim 8, including producing a V-shaped groove (6) formed on (111)- crystal planes by etching.

## Revendications

1. Tranche ou wafer avec des composants à semi-conducteur dans lequel les composants (2) sont reliés chacun à un cadre (1) par une attache (4) et façonnés dans ladite tranche ou ledit wafer en silicium (11), l'attache (4) reliant d'un côté le composant (2) au cadre (1), **caractérisée par le fait que** l'attache (4) présente un point de rupture prévu (6) pour la séparation mécanique du composant (2) du cadre (1).

2. Tranche ou wafer selon la revendication 1, **caractérisée par le fait que** l'attache (4) est formée d'un épaississement plan (5) du cadre et par un creux (6) entre le cadre (1) et le composant à semi-conducteur (2).

3. Tranche ou wafer selon la revendication 2, **caractérisée par le fait que** le creux (6) est en forme de V.

4. Tranche ou wafer selon la revendication 3, **caractérisée par le fait que** les surfaces (7) du creux en V constituent des plans cristallographiques (111).

5. Procédé de fabrication d'une tranche ou d'un wafer selon la revendication 1, **caractérisé par** les étapes suivantes :
structuration photolithographique de la face arrière du wafer avec l'attache unilatérale (4) qui relie chacun des composants à semi-conducteur (2) au cadre (1) et
dégagement des composants (2) et du cadre (1) par structuration photolithographique de la face avant et/ou arrière du wafer suivie de processus de gravure chimique sèche ou humide pour le façonnage.

6. Procédé selon la revendication 5, **caractérisé par le fait que** l'on réalise un creux (6) en guise de point de rupture prévu.

7. Procédé selon la revendication 6, **caractérisé par le fait que** le creux est un creux en V (6).

8. Procédé selon la revendication 7, **caractérisé par le fait que** le creux en V (6) est réalisé par gravure anisotrope humide.

9. Procédé selon la revendication 8, **caractérisé par le fait que** l'on réalise lors de la gravure un creux en V (6) dont les surfaces constituent des plans cristallographiques (111).
